(19) **Europäisches Patentamt**

**European Patent Office**

**Office européen des brevets**

(11) **EP 0 945 872 B1**

(12) **EUROPÄISCHE PATENTSCHRIFT**

(45) Veröffentlichungstag und Bekanntmachung des Hinweises auf die Patenterteilung:
**31.05.2006 Patentblatt 2006/22**

(51) Int Cl.:
*G11C 16/10* *(2006.01)*     *G11C 17/08* *(2006.01)*

(21) Anmeldenummer: **99103413.3**

(22) Anmeldetag: **22.02.1999**

(54) **Verfahren zur Programmierung einer Festwert-Speicherzellenanordnung**

Method for programming a read only memory

Procédé de programmation d'une mémoire morte

(84) Benannte Vertragsstaaten:
**DE FR GB IE IT NL**

(30) Priorität: **23.03.1998 DE 19812640**

(43) Veröffentlichungstag der Anmeldung:
**29.09.1999 Patentblatt 1999/39**

(73) Patentinhaber: **Infineon Technologies AG**
**81669 München (DE)**

(72) Erfinder:
• **Schmitt-Landsiedel, Doris, Prof.**
**85521 Ottobrunn (DE)**
• **von Basse, Paul-Werner**
**82515 Wolfratshausen (DE)**
• **Thewes, Roland, Dr.**
**82194 Gröbenzell (DE)**
• **Bollu, Michael, Dr.**
**81671 München (DE)**

(74) Vertreter: **Patentanwaltskanzlei WILHELM &**
**BECK**
**Nymphenburger Strasse 139**
**80636 München (DE)**

(56) Entgegenhaltungen:
**US-A- 4 725 986     US-A- 4 858 194**
**US-A- 5 623 444     US-A- 5 715 194**

**Beschreibung**

Die Erfindung bezieht sich auf ein Verfahren zur Programmierung einer Festwer-Speicherzellenanordnung nach dem Oberbegriff des Anspruches 1.

Die auch als Nur-Lese-Speicher oder Read-Only-Memory bezeichneten Festwertspeicher finden zur Speicherung von Daten in vielen elektronischen Systemen Verwendung. Solche Speicher, bei denen die Daten in digitaler Form fest eingeschrieben sind, werden realisiert als auf der Basis eines Halbleitermaterials, insbesondere Silizium, integriert ausgebildeter Silizium-Schaltungen, in welcher als Speicherzellen vorzugsweise MOS-Transistoren verwendet werden. Beim Auslesen werden die einzelnen Speicherzellen über die Gateelektrode der MOS-Transistoren, die mit einer Wortleitung verbunden ist, ausgewählt. Der Eingang jedes MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden den abgespeicherten Daten die logischen Werte Null und Eins zugeordnet. Technisch wird die Speicherung von Null und Eins bei diesen Festwertspeichern dadurch bewirkt, dass in Speicherzellen, in denen der den Zustand "kein Stromfluß durch den Transistor" zugeordnete logische Wert gespeichert ist, kein MOS-Transistor hergestellt wird oder keine leitende Verbindung zur Bitleitung realisiert wird. Alternativ können für die beiden logischen Werte entsprechend MOS-Transistoren realisiert werden, die durch unterschiedliche Implantationen im Kanalgebiet unterschiedliche Einsauzspannungen aufweisen. Ein solcher Siliziumspeicher besitzt einen im wesentlichen planaren Aufbau mit einem pro Speicherzelle minimalen Flächenbedarf, der bei der heutigen Ein-$\mu$m-Technologie typische Speicherdichten von etwa 0,14 Bit/$\mu m^2$ ergibt.

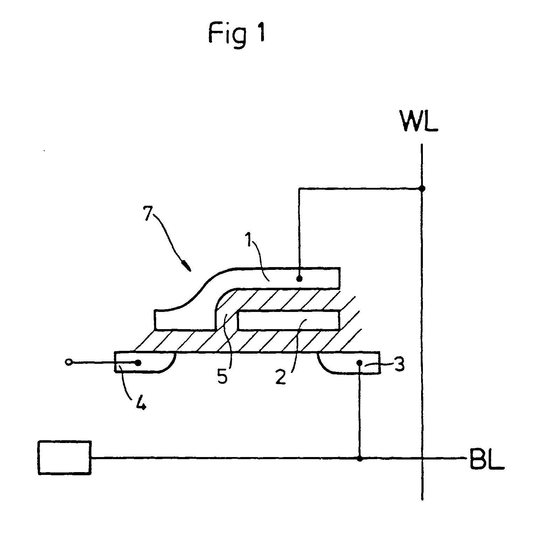

Die Erfindung richtet sich in erster Linie zur Herstellung von einmalig elektrisch programmierbaren Festwert-Speichern, sogenannte OTP -Speicher = One-Time-Programmable-Memory, bei denen das Gatedielektrikum in aller Regel insbesondere ein ONO-Formierungsmaterial aufweist, kann aber dem Prinzip nach auch bei mehrfach programmierbaren Festwert-speichern, den sogenannten MTP-ROM-Speichern, bei denen das Gatedielektrikum insbesondere ein Gateoxid (Fig. 1) aufweist, Anwendung finden.

Während des Programmiervorganges einer Speicherzelle durch sehr hohe Spannungen (beispielsweise vermittels des bekannten Fowler-Nordheim-Mechanismus) müssen die Nachbarzellen der betroffenen Zellen, die im Zellenfeld matrixförmig organisiert sind, geschützt werden. Üblicherweise erfolgt dies durch Anlegen einer Blockierspannung an die Bitleitungen und einer Schutzspannung an die Wortleitungen der zu schützenden Zellen, wodurch die Spannungen an diesen Nachbarzellen klein genug gehalten werden können. Die Zuführung der Spannungen erfolge vermittels Decoder, welche mit entsprechenden Hochvoltschaltern ausgestattet sind. Normalerweise arbeitet der Wortdecoder während des Programmiervorganges als (1 aus n)-Decoder. Er verbindet hierbei eine Leitung mit der höheren Programmierspannung, wobei alle übrigen Decoderausgänge auf der Schutzspannung verbleiben. Der Bitdecoder arbeitet während des Programmiervorgangs gleichfalls als (1 aus n)-Decoder. Dieser verbindet eine Leitung mit dem Massepotential, wobei die übrigen Bitleitungen auf dem Blockierpotential verbleiben. Der Blockierdecoder arbeitet typischerweise als (n-1 aus n)-Decoder und verbindet sämtliche Bitleitungen, auf denen kein Informationswert programmiert werden soll, mit dem Blockierpotential. Die eine verbleibende Leitung wird durch den Bitdecoder auf Massepotential gehalten. Die bisher bekannten Verfahren zur Programmierung eines OTP-Speichers erfordern vergleichsweise aufwendige Decoderschaltungen und sind dennoch relativ langsam.

Aus der US-Patentschrift 4.858.194 ist ein nichtflüchtiger Halbleiterspeicher bekannt, bei dem die Bitleitungen und Wortleitungen vor dem Schreiben auf eine feste Blockierspannung vorgeladen werden und erst beim Schreiben eine zugehörige Bitleitung und eine zugehörige Wortleitung auf ein jeweiliges, von der einzuschreibenden Information abhängiges, Potential gebracht wird.

Ein Verfahren mit den Merkmalen des Oberbegriffs des Anspruchs 1 ist aus der US 4,858,194 bekannt. Diese Druckschrift zeigt ein Verfahren zur Programmierung eines Festwert-Speicherzellenfelds, bei dem die Bitleitungen und die Wortleitung vor dem Schreiben auf eine feste Blockierspannung vorgeladen und erst beim Schreiben einer zugehörigen Bitleitung und einer zugehörigen Wortleitung auf das jeweilige, von der einzuschreibenden Information abhängige Potential gebracht wird. Aus der US 5,623,444 ist weiter ein Verfahren bekannt, bei dem bei Festwertspeichern die Schreibzeit sich dadurch verkürzen lässt, dass zusätzlich an den Bitleitungen ein kapazitives Element in Form einer Sub-Bitleitung vorgesehen ist, die über die Bitleitung aufgeladen wird, um ein schnelleres Einschreiben in die Speicherzelle zu ermöglichen.

Der Erfindung liegt die Aufgabe zugrunde, ein Verfahren zur Herstellung bzw. Programmierung einer Festwert-Speicherzellenanordnung auf Halbleiterbasis, insbesondere eines OTP-Festwertspeichers zur Verfügung zu stellen, welches eine schaltungstechnische Vereinfachung der Decoder und gleichzeitig eine Beschleunigung des Programmiervorganges bietet.

Diese Aufgabe wird durch ein Verfahren gemäß Anspruch 1 gelöst.

Erfindungsgemäß ist vorgesehen, dass die zu programmierenden Informationswerte im Zellenfeld des Speichers dynamisch vor- bzw. zwischengespeichert werden. Das erfindungsgemäße dynamische Zwischenspeicherverfahren ermöglicht eine wesentliche Vereinfachung der an der Programmierung betroffenen Decoderschaltungen und gleichzeitig eine deutliche Beschleunigung des Programmiervorganges.

Bei dem besonders bevorzugten Verfahren nach der Erfindung werden in nachfolgender Reihenfolge folgende Schritte durchgeführt:

a; Über den Blockierdecoder werden alle Bitleitungen auf das Blockierpotential (VB) vorgeladen,

b) alle Ausgänge des Wortdecoders werden auf die Schutzspannung (VS) gelegt, wodurch alle Speicherzellen des Zellenfeldes leitend werden und das Blockierpotential in das gesamte Zellenfeld übertragen wird,

c) der Blockierdecoder wird vollstandig vom Zellenfeid entkoppelt, wodurch das Blockierpotential (VB) auf sämtlichen Kapazitäten der Bitleitungen (BL) gespeichert bleibt,

d) der Bitdecoder wird eingeschaltet und verbindet eine Bitleitung mit der Leitung, die den zu programmierenden Informationswert enthält, wobei auf die Bitleitung dieser Informationswert übertragen wird,

e) über den Wortdecoder wird eine Wortleitung ausgewählt und auf das Programmierpotential (VP) gelegt, am Kreuzungspunkt dieser Wortleitung mit der vorher ausgewählten Bitleitung wird die Speicherzelle programmiert,

f) abschließend werden Wort- und Bitdecoder abgeschaltet.

Weitere zweckmäßige Weiterbildungen der Erfindung ergeben sich aus den Unteransprüchen.

Nachfolgend wird die Erfindung anhand von in der Zeichnung dargestellten Ausführungsbeispielen weiter erläutert. Im Einzelnen zeigen die schematischen Darstellungen in:

Figur 1      eine schematische Darstellung einer OTP-Speicherzelle;

Figur 2A     eine schematische Darstellung des Zellenfeldes mit Decoderschaltungen zur Erläuterung der Spannungen im Zellenfeld bei der Programmierung einer Zelle;

Figur 2B     eine Übersicht der Zellen von Figur 2A;

Figur 3A     eine schematische Darstellung eines (1 aus 8) - Decoders, NAND- oder Seriendecoders;

Figur 3B     eine schematische Darstellung eines (7 aus 8) - Decoders, NOR- oder Parallel-Decoders;

Figur 4A     eine schematische Darstellung eines Einzelschalters mit decodierter Ansteuerung;

Figur 4B     eine schematische Darstellung eines Sammelschalters mit einer Ansteuerung;

Figur 5      eine schematische Darstellung des prinzipiellen Aufbaues eines Speicherfeldes mit MOS-Transistoren;

Figur 6      eine schematische Kurvendarstellung zur Erlauterung des Programmierablaufes bei dem Speicherfeld nach Figur 5;

Figur 7      die Anzahl der in einem Programmierzyklus programmierten Zellen in einem segmemierten Speicher bei Zwischenspeicherung des Blockierpotentials;

Figur 8      die Anzahl der in einem Programmierzyklus programmierten Zellen in einem segmentierten Speicher bei Zwischenspeicherung von 1 Bit pro Segment; und

Figur 9      die Anzahl der in einem Programmierzyklus programmierten Zellen in einem segmentierten Speicher bei Zwischenspeicherung von 1 Zeile pro Segment.

Da bei elektrisch programmierbaren und loschbaren Halbleiterspeichern die erfindungsgemäße Testschaltung besonders vorteilhaft angewendet werden kann, beziehen sich die nachfolgend naher erläuterten Ausführungsbeispiele sämtlich auf elektrisch programmierbare und löschbare Halbleiterspeicher mit OTP- (einmal programmierbaren) oder MTP- (mehrfach programmierbaren) Speicherzellen.

In Figur 1 ist schematisch eine einzelne Speicherzelle 7 eines Festwertspeichers dargestellt, welche eine Steuerelektrode 1, eine potentialungebundene Elektrode 2, eine Drainelektrode 3 und eine Sourceelektrode 4 besitzt. Die potentialungebundene Elektrode 2 ist von einem Isolator 5 umgeben. Die Steuerelektrode 1 ist an einer der Speicherzelle 7 übergeordneten Zeile zugeordneten Wortleitung WL, die Drainelektrode 3 an einer der Speicherzelle 7 übergeordneten Spalte zugeordneten Bitleitung BL elektrisch gekoppelt. Die Sourceanschlüsse 4 der Speicherzellen sind miteinander gekoppelt und liegen auf einem gemeinsamen, festlegbaren Potential. Diese Speicherzelle funktioniert in an sich bekannter Weise wie folgt. Den beiden Zuständen der Speicherzelle 7 entspricht der geladene und der ungeladene Zustand der potentialungebundenen Elektrode 2. Zum Programmieren werden Ladungen in die potentialungebundene Elektrode 2 injiziert, indem an die Steuerelektrode 1 eine positive Hochspannung gegen die Drainelektrode 3 angelegt wird. Der Wert der positiven Hochspannung liegt typischerweise bei etwa + 12 Volt. Zum Löschen werden Elektronen von der potentialungebundenen Elektrode 2 entfernt, beziehungsweise es werden Löcher in die potentialungebundene Elektrode 2 injiziert, indem eine negative Hochspannung an die Steuerelektrode 1 gegen die Drainelektrode 3 gelegt wird, deren Wert typischerweise bei etwa - 12 Volt liegt. Diese betragsmäßig die Versorgungsspannung übersteigenden Spannungen sind notwendig, um die vom Isolator 5 aufgebaute Potentialbarriere zu überwinden. Aufgrund der hohen elektrischen Feldstärke können Elektronen die Potentialbarriere der Isolatoren durchtunneln ("Fowler-Nordheim-Effect") oder es können in Näder Drainelektrode entstandene heiße Elektronen der Isolator überwinden ("Channel-Hot-Elektron-Effect"). Zum Lesen wird eine positive Spannung von etwa 4 Volt zwischen der Steuerelektrode und der Drainelektrode 3 angelegt, die jedoch nicht ausreicht, den Ladungszustand der potentialungebundenen Elektrode 2 zu ändern.

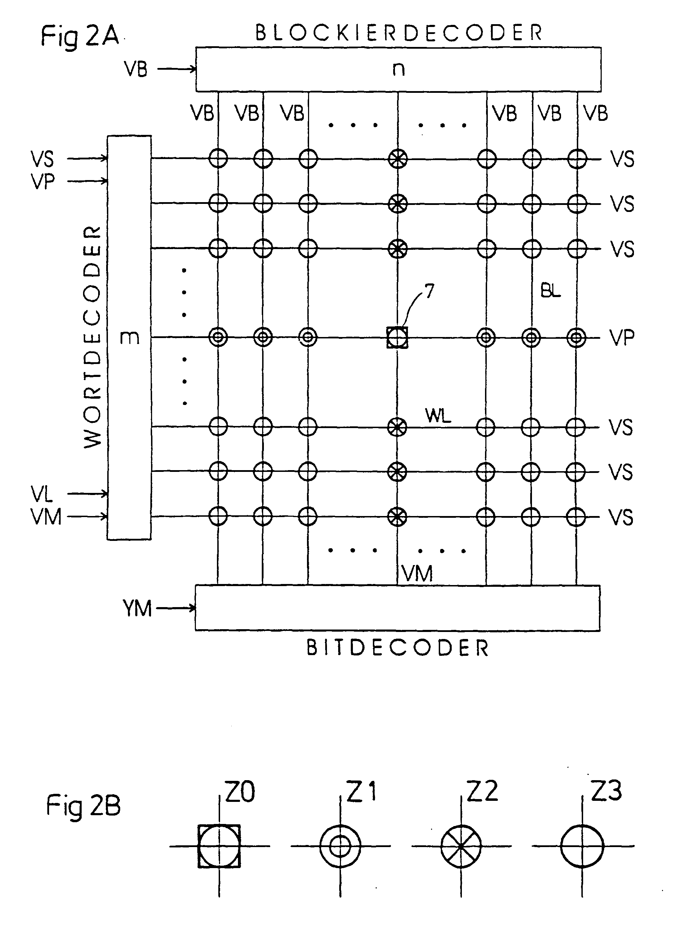

Zum besseren Verständnis des erfindungsgemäßen Verfahrens wird zunächst erläutert, wie das der Erfindung zugrunde liegende technische Problem bisher gelöst wurde. Figur 2A zeigt hierzu die prinzipielle Ansteuerung eines Zellenfeldes, wobei die Spannungen im Zellenfeld bei der Programmierung einer Zelle folgendes bedeuten:

VL = Leseauswahl-Potential (4 Volt)
VP = Programmier-Potential (12 Volt)
VM = Masse-Potential (0 Volt;
VS = Schutz-Potential (8 Volt)
VB = Blockier-Potential (4 Volt).

Die unterschiedlich dargestellten Zellen bedeuten nach Figur 2B das Folgende:

Z0 = zu programmierende Zelle (12 V - 0 V = 12 V)
Z1 = gestresste Zelle auf hohen Potential (12 V - 4 V = 8 V)
Z2 = gestresste Zelle auf niedrigem Potential (8V - 0V = 8V)
Z3 = ungestresste Zelle (8 V - 4 V = 4 V)

Normalerweise liegt der Wortdecoder außerhalb des Zellenfeldes. Hierbei ist es möglich, die Funktion (I aus n) durch gesteuerte Inversion über ein EXOR-Gatter in eine (n - 1 aus n)-Funktion umzusetzen:

$$\text{INV (1 aus n)} = \text{(n-1 aus n)}$$

Bei einer gesteuerten Inversion gilt:

$$y = \text{EXOR (W,x)}$$

$$y = /x \text{ für W} = 1$$

$$Y = x \text{ für W} = 0$$

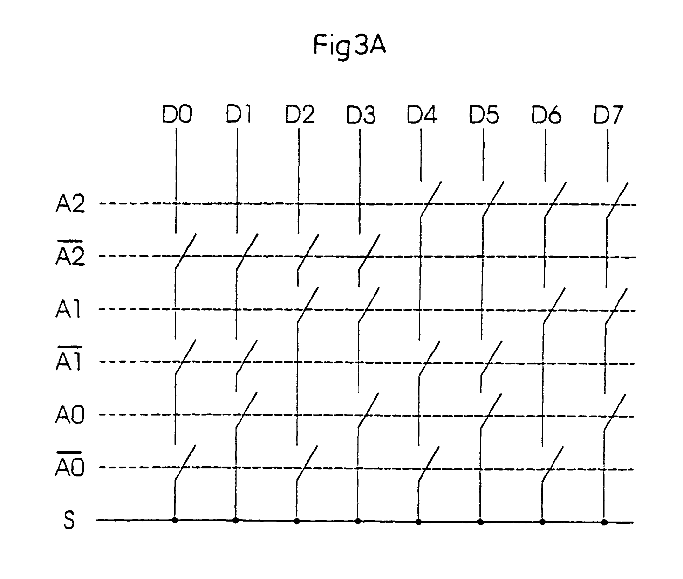

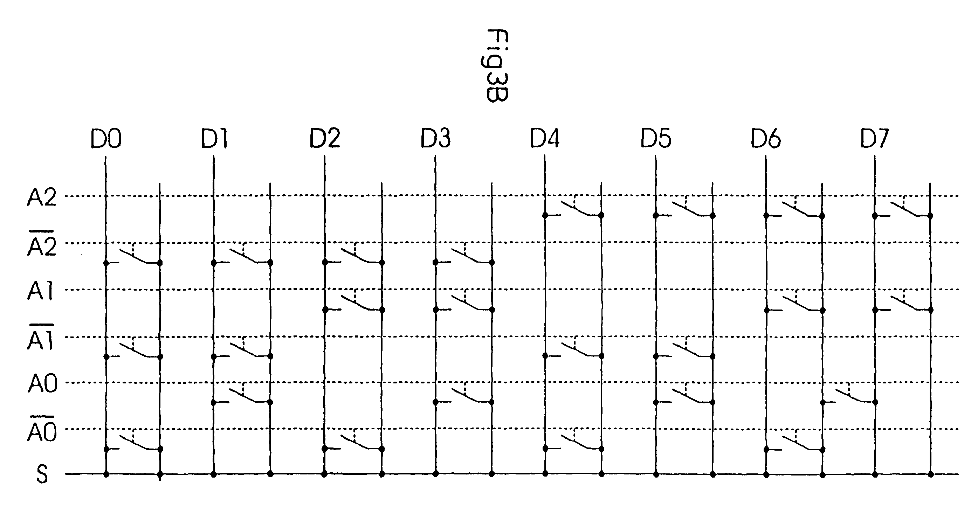

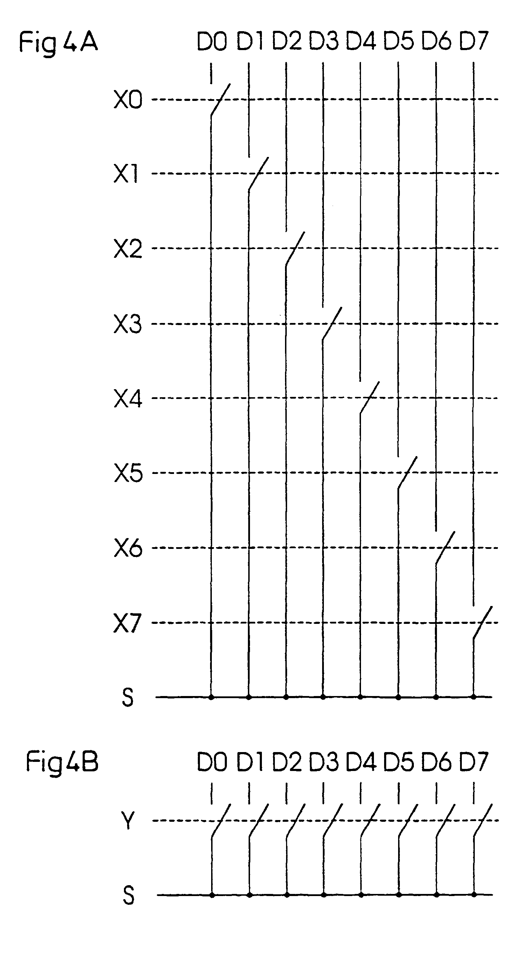

Der Bitdecoder und der Blockierdecoder liegen meistens im Zellenfeld. Hier kann nur eine Funktion realisiert werden, entweder die Funktion (I aus n) mit NAND-Decoder (Serienschalter) (schematisch dargestellt in Fig. 3A), oder die Funktion (n - 1 aus n) mit NOR-Decoder (Parallelschalter) (schematisch dargestellt in Fig. 3B). Werden beide Funktionen benotigt, wie beim oben beschriebenen Bit- und Biokkierdecoder, so muss einer der beiden Decoder durch Einzelschalter ersetzt werden, die von decodierten Signalen gesteuert werden (Fig. 4A). Diese Einzelschalter sind sehr platzaufwendig.

Gunstig für das dynamische Zwischenspeicherverfahren im Zellenfeld vor der Programmierung nach der Erfindung sind:

a) Kleine kapazitive Verkopplungen zwischen Wortleitungen WL und Bitleitungen BL im Zellenfeld.

b) Kleine kapazitive Verkopplungen zwischen Adressleitungen der Decoder und den Bitleitungen im Zellenfeld.

c) Kleiner Ladungsbedarf für die Programmierung einer Zelle im Zellenfeld.

d) Kleine Leckströme der Bitleitungen untereinander und zum Substrat (d.h. keine Speicherzellen zwischen den Bitleitungen) .

Durch die Einhaltung dieser Voraussetzungen wird verhindert, dass Störungen auf den Bitleitungen, die durch die Ansteuerung der Decoder auftreten, die gespeicherten Pegel auf den Bitleitungen des Zellenfeldes erheblich verändern.

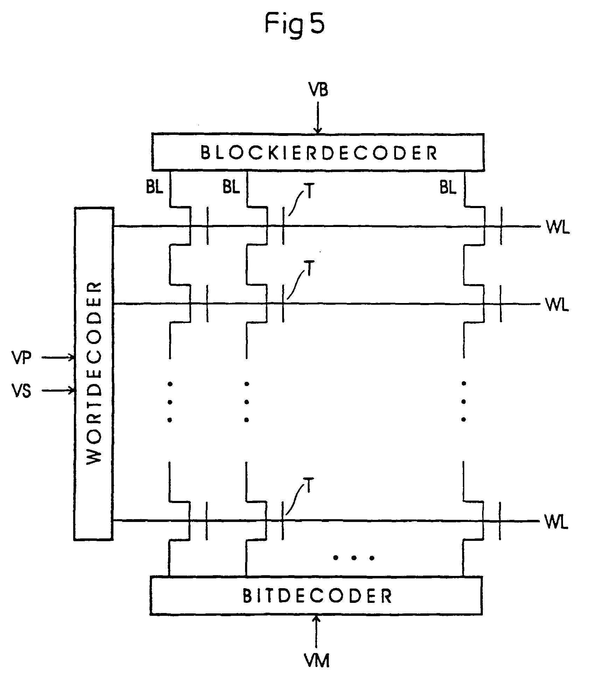

Die Voraussetzungen werden von z.B. Speichern mit MOS-Transistoren T als Zellen nach Fig. 5 erfüllt, bei denen die Information durch unterschiedliche Schwellspannungen der MOS-Transistoren gespeichert ist. Die unterschiedlichen Schwellspannungen werden durch Einlagerung von Ladungen in dem Gate-Isolator (z.B. ONO) durch Tunnelströme erreicht.

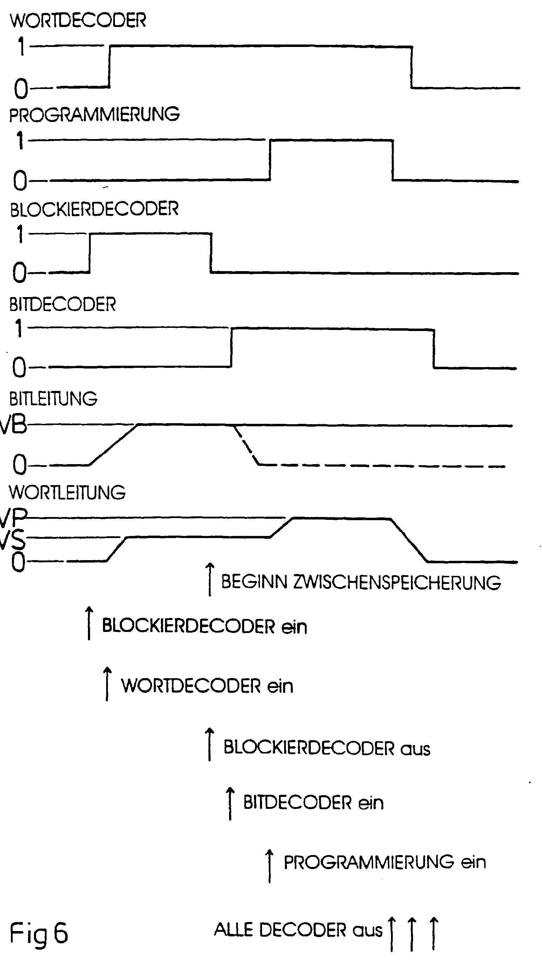

Die einfachste Form der dynamischen Zwischenspeicherung besteht darin, das Blockierpotential VB auf den Bitleitungen BL kapazitiv zu speichern, auf denen keine Zelle programmiert werden soll. Der Vorgang läuft auch unter Bezugnahme auf Fig. 6 folgendermaßen ab:

a) Über den Blockierdecoder werden alle Bitleitungen BL auf das Blockierpotential vorgeladen. Während dieser Zeit sperrt der Bitdecoder komplett, d.h. auf allen Leitungen BL des Zellenfeldes.

b) Alle Ausgange des Wortdecoders werden auf die Schutzspannung (VS) gelegt, damit alle Speicherzellen im Zellenfeld leitend werden und das Blockierpotential in das gesamte Zellenfeld übertragen wird.

c) Der Blockierdecoder wird vollstandig vom Zellenfeld abgetrennt. Jetzt bleibt das Blockierpotential (VB) auf allen Kapazitäten der Bitleitungen (BL) gespeichert.

d) Der Bitdecoder wird eingeschaltet und verbindet eine Bitleitung mit der Leitung, die den zu programmierenden Informationswert enthält. Auf die Bitleitung wird dieser Informationswert übertragen ("1" = VB, "0" = VM).

e) Als letztes wird über den Wortdecoder eine Wortleitung WL ausgewählt und auf das Programmierpotential VP gelegt. Am Kreuzungspunkt dieser Wortleitung WL mit der vorher ausgewahlten Bitleitung BL wird die Zelle programmiert.

f) Abschließend werden Wort- und Bitdecoder abgeschaltet.

Beim Programmiervorgang wurde also die Information dem Zellenfeld statisch zugeführt und nur das Blockierpotential in den Bitleitungen gespeichert. Da bei diesem Verfahren der Blockierdecoder nur zum Vorladen aller Bitleitungen benutzt wird und keine Decoderfunktion mehr benötigt, kann er durch eine einfache Schalterreihe nach Fig. 4B ersetzt werden, was zu einer wesentlichen Platzersparnis fuhrt.

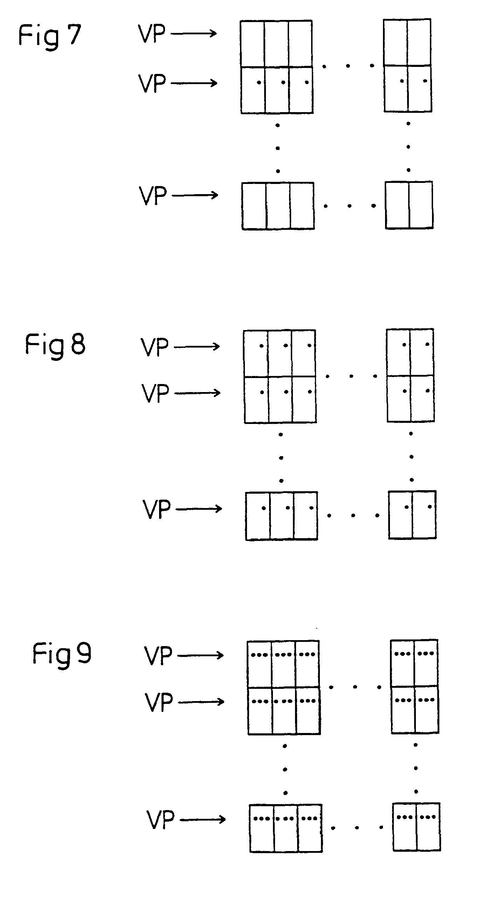

Eine Beschleunigung des Programmiervorgangs und eine Verringerung der Stressbeanspruchung der nicht zu programmierenden Zellen wird durch diese Maßnahme noch nicht erreicht, auch dann nicht, wenn das Zellenfeld nach der schematischen Darstellung nach Fig. 7 segmentiert ist.

Eine weitere Verkürzung der Programmierzeiten und Stresszyklen erhält man, wenn neben dem Blockierpotential auch noch der zu programmierende Informationswert auf den Bitleitungen BL entsprechend der schematischen Darstellung nach Fig. 8 zwischengespeichert wird. Der Vorgang läuft folgendermaßen ab:

Zunächst sind die Schritte a) bis d) die gleichen wie vorher beschrieben.

e) Die Bitdecoder naben nur jeweils zu einer Spur Zugang. Nach dem Übertragen der Information in die Segmente einer Spur werden die Bitdecoder wieder abgetrennt. Die Segmente dieser Spur speichern also nicht nur die Blockierspannung VB kapazitiv, sondern auch die Information.

f) Dem Speicher wird die Information der nachsten Spur zugeführt. Daraufhin wird der Bitdecoder dieser Spur eingeschaltet. Die Information gelangt in diese Spur und wird dort zwischengespeichert. Anschließend wird der Bitdecoder wieder abgetrennt.

g) Der Schritt f) wird solange wiederholt, bis in allen Spuren in allen Segmenten jeweils auf einer Bitleitung die zu programmierende Information zwischengespeichert ist.

h) Erst jetzt wird über den Wortdecoder eine Wortleitung ausgewählt und auf das Programmierpotential (VP) gelegt. Diese gelangt an alle Spuren, so dass in jedem Segment aller Spuren ein Bit programmiert wird.

i) Nach Beendigung der Programmierzeit wird der Wortdecoder wieder abgeschaltet.

Durch die große Anzahl parallel programmierter Zellen reduziert sich die Anzahl der Programmierzyklen auf die Anzahl der Zellen pro Segment. Die Anzahl der Stresszyklen für die nicht programmierten Zellen wird auf die Anzahl der Spalten plus die Anzahl der Zeilen in einem Segment verkleinert (demgegenüber war bei der bisherigen Lösung die Anzahl der Stresszyklen = die Zahl der zu programmierenden Zellen).

Ein weiterer Schritt zur Verkürzung der Programmierzeit für den gesamten Speicher besteht darin, ganze Zeilen der zu programmierenden Informationswerte in den Bitleitungen der Segmente vorzuspeichern. Dies ist in Figur 9 schematisch angedeutet. Der Vorgang läuft folgendermaßen ab:

Zunächst sind die Schritte a) bis g) die gleichen wie oben beschrieben.

i) Sobald in allen Segmenten aller Spuren ein Bit gespeichert isz, wird die Bitadresse gewechselt und wieder in der ersten Spur begonnen, das zweite Bit zu speichern.

j) Diesen Vorgang wiederholt man so lange, bis in jedem Segment in allen Spuren jeweils eine Zeile der zu programmierenden Information vorgespeichert ist.

k) Erst danach wird über den Wortdecoder eine Wortleitung ausgewählt und auf das Programmierpotential (VP) gelegt. Diese gelangt an alle Spuren, so dass in jedem Segment aller Spuren eine Zeile programmiert wird.

l) Nach Beendigung der Programmierzeit wird der Wortdecoder wieder abgeschaltet.

Die Zahl der parallel programmierten Zellen ist weiter gestiegen. Entsprechend wird die Zahl der Programmierzyklen auf die Anzahl der Zeilen im Segment verkleinert. Die Zahl der Stresszyklen für die nicht programmierten Zellen wird ebenfalls auf die Anzahl der Zeilen im Segment reduziert.

**Patentansprüche**

1. Verfahren zur Programmierung einer Festwertspeicherzellenanordnung, deren Speicherzellen in einem Zellenfeld matrixförmig in Wortleitungen und Bitleitungen organisiert sind, wobei die Bitleitungen vermittels einem Bitdecoder für die Beaufschlagung mit einem Massepotential (VM) und vermittels einem Blockierdecoder zur Beaufschlagung der Bitleitungen mit einem Blockierpotential (VB), und die Wortleitungen vermittels einem Wortdecoder für die Beaufschlagung der Wortleitungen mit einer Programmierpotential (VP) bzw. einer Schutzspannung (VS) angesteuert werden,
   **dadurch gekennzeichnet, dass**
   zuerst das Blockierpotential (VB) vom Blockierdecoder auf allen Bitleitungen im Zellenfeld vorgeladen wird,
   dann der Blockierdecoder vollständig vom Zellenfeld entkoppelt wird, wodurch das Blockierpotential (VB) auf sämtlichen Kapazitäten der Bitleitungen (BL) gespeichert bleibt,und anschließend der zu programmierende Informationswert auf den gewünschten Bitleitungen im Zellenfeld vorgespeichert wird, um anschließend ein paralleles Programmieren von Speicherzellen zu ermöglichen.

2. Verfahren nach Anspruch 1, **gekennzeichnet durch** folgende Schritte:

   a) Über den Blockierdecoder werden alle Bitleitungen auf das Blockierpotential (VB) vorgeladen,
   b) alle Ausgänge des Wortdecoders werden auf die Schutzspannung (VS) gelegt, wodurch alle Speicherzellen des Zellenfeldes leitend werden und das Blockierpotential in das gesamte Zellenfeld übertragen wird,
   c) der Blockierdecoder wird vollständig vom zellenfeld entkoppelt, wodurch das Blockierpotential (VB) auf sämtlichen Kapazitäten der Bitleitungen (BL) gespeichert bleibt,
   d) der Bitdecoder wird eingeschaltet und verbindet eine Bitleitung mit einer Leitung, die den zu programmierenden Informationswert enthält, wobei auf die Bitleitung dieser Informationswert übertragen wird,
   e) über den Wortdecoder wird eine Wortleitung ausgewählt und auf die Programmierpotential (VP) gelegt, am Kreuzungspunkt dieser Wortleitung mit der vorher ausgewählten Bitleitung wird die Speicherzelle programmiert, und

f) abschließend werden Wort- und Bitdecoder abgeschaltet.

3. Verfahren nach Anspruch 2, **gekennzeichnet durch** die weiteren Schritte:

g) Nach dem Übertragen des Informationswertes in die Segmente einer Spur des Zellenfeldes werden die Bitdecoder wieder abgetrennt, wodurch die Segmente dieser Spur nicht nur das Blockierpotential (VB) kapazitiv speichern, sondern auch den übertragenen Informationswert,

h) dem Zellenfeld wird ein Informationswert der nächsten Spur zugeführt, anschließend wird der Bitdecoder dieser nächsten Spur eingeschaltet, wodurch der Informationswert in diese nächste Spur gelangt und dort zwischengespeichert wird, und anschließend der Bitdecoder wieder abgetrennt wird,

i) der Schritt h) wird solange wiederholt, bis in allen Spuren in allen Segmenten des Zellenfeldes jeweils auf einer Bitleitung der zu programmierende Informationswert zwischengespeichert ist, und

j) daran anschließend wird über den Wortdecoder eine Wortleitung ausgewählt und mit der Programmierspannung (VP) beaufschlagt.

4. Verfahren nach Anspruch 3, **gekennzeichnet durch** den Schritt:

k) Nach Beendigung der Programmierzeit wird der Wortdecoder wieder abgeschaltet.

5. Verfahren nach Anspruch 3, **gekennzeichnet durch** die weiteren Schritte:

l) Sobald in allen Segmenten aller Spuren des Zellenfeldes der Informationswert gespeichert ist, wird die Bitadresse gewechselt und wieder in der ersten Spur begonnen, den nächsten Informationswert zu speichern,

m) der Vorgang nach dem Schritt 1) wird solange wiederholt, bis in jedem Segment in allen Spuren des Zellenfeldes jeweils auf einer Bitleitung der zu programmierende Informationswert vorgespeichert ist,

n) danach wird über den Wortdecoder eine Wortleitung ausgewählt und auf das Programmierpotential (VP) gelegt,

o) nach Beendigung der Programmierzeit wird der Wortdecoder wieder abgeschaltet.


**Claims**

1. Method for programming a read-only memory cell arrangement whose memory cells are organized in word lines and bit lines in the form of a matrix in a cell array, the bit lines being driven by means of a bit decoder in order to apply an earth potential (VM) to said bit lines and being driven by means of a blocking decoder in order to apply a blocking potential (VB) to the bit lines, and the word lines being driven by means of a word decoder in order to apply a programming potential (VP) or a protective voltage (VS) to the word lines,

**characterized in that**

the blocking potential (VB) is first of all precharged, by the blocking decoder, on all of the bit lines in the cell array, the blocking decoder is then completely decoupled from the cell array, as a result of which the blocking potential (VB) remains stored in all of the capacitances of the bit lines (BL), and

the information value to be programmed is then prestored on the desired bit lines in the cell array in order to then make it possible to program memory cells in a parallel manner.

2. Method according to Claim 1, **characterized by** the following steps:

a) the blocking decoder is used to precharge all of the bit lines to the blocking potential (VB),

b) all of the outputs of the word decoder are connected to the protective voltage (VS), as a result of which all of the memory cells of the cell array are turned on and the blocking potential is transmitted to the entire cell array,

c) the blocking decoder is completely decoupled from the cell array, as a result of which the blocking potential (VB) remains stored in all of the capacitances of the bit lines (BL),

d) the bit decoder is switched on and connects a bit line to a line that contains the information value to be programmed, this information value being transmitted to the bit line,

e) the word decoder is used to select a word line and to connect it to the programming potential (VP), and the memory cell is programmed at the crossover point between this word line and the previously selected bit line, and

f) the word and bit decoders are finally switched off.

**3.** Method according to Claim 2, **characterized by** the following further steps:

g) the bit decoders are disconnected again after the information value has been transmitted to the segments of a track of the cell array, as a result of which the segments of this track capacitively store not only the blocking potential (VB) but also the information value that has been transmitted,
h) an information value of the next track is supplied to the cell array, the bit decoder of this next track is then switched on, as a result of which the information value reaches this next track and is buffer-stored there, and the bit decoder is then disconnected again,
i) step h) is repeated until the information value to be programmed has been respectively buffer-stored on a bit line in all of the tracks in all of the segments of the cell array, and
j) the word decoder is then used to select a word line and to apply the programming voltage (VP) to said word line.

**4.** Method according to Claim 3, **characterized by** the following step:

k) the word decoder is disconnected again after the programming time has ended.

**5.** Method according to Claim 3, **characterized by** the following further steps:

1) as soon as the information value has been stored in all of the segments of all of the tracks of the cell array, the bit address is changed and the process begins again, in the first track, to store the next information value,
m) the operation according to step 1) is repeated until the information value to be programmed has been respectively prestored on a bit line in each segment in all of the tracks of the cell array,
n) the word decoder is then used to select a word line and to connect it to the programming potential (VP),
o) the word decoder is disconnected again after the programming time has ended.

**Revendications**

**1.** Procédé pour la programmation d'un agencement de cellules de mémoire morte, dont les cellules de mémoire sont organisées dans un champ de cellules sous forme matricielle en circuits de mots et circuits de bits, les circuits de bits étant commandés au moyen d'un décodeur de bit pour l'alimentation en un potentiel de masse (VM) et au moyen d'un décodeur de blocage pour l'alimentation des circuits de bits en un potentiel de blocage (VB), et les circuits de mots au moyen d'un décodeur de mot pour l'alimentation des circuits de mots en un potentiel de programmation (VP) ou d'une tension de protection (VS), **caractérisé en ce que** le potentiel de blocage (VB) d'abord est préchargé par le décodeur de blocage sur tous les circuits de bits dans le champ de cellules, puis le décodeur de blocage est découplé complètement du champ de cellules, ce qui permet au potentiel de blocage (VB) de rester enregistré sur des capacités entières des circuits de bits (BL), et enfin la valeur d'information à programmer est préenregistrée sur les circuits de bits souhaités dans le champ de cellules, pour finalement permettre une programmation parallèle de cellules de mémoire.

**2.** Procédé selon la revendication 1, **caractérisé par** les étapes suivantes :

a) par le décodeur de blocage, tous les circuits de bits sont préchargés sur le potentiel de blocage (VB),
b) toutes les sorties du décodeur de mot sont placées sur la tension de protection (VS), moyennant quoi toutes les cellules de mémoire du champ de cellules deviennent conductrices et le potentiel de blocage est transmis dans tout le champ de cellules,
c) le décodeur de blocage est entièrement découplé du champ de cellules, le potentiel de blocage restant enregistré sur des capacités entières des circuits de bits (BL),
d) le décodeur de bit est mis en fonction et relie un circuit de bits à un circuit, qui contient la valeur d'information à programmer, cette valeur d'information étant transmise au circuit de bits,
e) par le décodeur de mot, un circuit de mots est sélectionné et placé sur le potentiel de programmation (VP), la cellule de mémoire est programmée au point de rencontre de ce circuit de mots et du circuit de bits précédemment sélectionné, et
f) enfin, le décodeur de mot et le décodeur de bit sont déconnectés.

**3.** Procédé selon la revendication 2, **caractérisé par** les étapes suivantes :

g) après transmission de la valeur d'information dans les segments d'une piste du champ de cellules, les décodeurs de bits sont de nouveau coupés, ce qui permet aux segments de cette piste d'enregistrer non seulement de manière capacitive le potentiel de blocage (VB), mais aussi la valeur d'information transmise.

h) au champ de cellules est conduite une valeur d'information de la piste suivante, puis le décodeur de bit de cette piste suivante est mis en fonction, ce qui permet à la valeur d'information de parvenir dans cette piste suivante et d'y être enregistrée de manière temporaire, puis au décodeur de bit d'être de nouveau coupé,

i) l'étape h) se répète jusqu'à ce que dans toutes les pistes de tous les segments du champ de cellules, la valeur d'information soit chaque fois enregistrée de manière temporaire sur un circuit de bits, et

j) ensuite un circuit de mots est sélectionné par le décodeur de mot et alimenté en tension de programmation (VP).

4.  Procédé selon la revendication 3, **caractérisé par** l'étape suivante :

k) à la fin du temps de programmation, le décodeur de mot est de nouveau déconnecté.

5.  Procédé selon la revendication 3, **caractérisé par** les autres étapes suivantes :

1) dès que la valeur d'information est enregistrée dans tous les segments de toutes les pistes du champ de cellules, on change d'adresse de bit et on recommence, dans la première piste, à enregistrer la valeur d'information suivante,

m) la procédure de l'étape 1) est répétée aussi longtemps que dans chaque segment de toutes les pistes du champ de cellules la valeur d'information à programmer est chaque fois préenregistrée sur un circuit de bits,

n) ensuite un circuit de mots est sélectionné par le décodeur de mot et placé sur le potentiel de programmation (VP),

o) à la fin du temps de programmation, le décodeur de mot est de nouveau déconnecté.

## Fig 1

Fig 2A

BLOCKIERDECODER

VB → | n |

VB | VB | VB | . . . | . . . | VB | VB | VB

VS →
VP →

WORTDECODER m

VL →
VM →

VS
VS
VS

BL

7

VP

WL

VS
VS
VS

VM

YM → | |

BITDECODER

Fig 2B

Z0   Z1   Z2   Z3

## Fig 3A

Fig3B

Fig 4A

Fig 4B

## Fig 5

WORTDECODER

PROGRAMMIERUNG

BLOCKIERDECODER

BITDECODER

BITLEITUNG

$\sqrt{B}$

0

WORTLEITUNG

$\sqrt{P}$
$\sqrt{S}$

0

↑ BEGINN ZWISCHENSPEICHERUNG

↑ BLOCKIERDECODER ein

↑ WORTDECODER ein

↑ BLOCKIERDECODER aus

↑ BITDECODER ein

↑ PROGRAMMIERUNG ein

Fig 6                              ALLE DECODER aus ↑ ↑ ↑

Fig 7

VP ⟶

VP ⟶

VP ⟶

Fig 8

VP ⟶

VP ⟶

VP ⟶

Fig 9

VP ⟶

VP ⟶

VP ⟶